# EUROPEAN PATENT APPLICATION

(11) **EP 0 624 801 A1**
(43) Date of publication of application: **17.11.1994**
(21) Application number: 94105335.7
(22) Date of filing: 06.04.1994
(51) Int. Cl.: G01R 1/067

(54) **Inspection apparatus, inspection method and semiconductor device**

(30) Priority: 09.04.1993 JP 83566/93
(71) Applicant: MATSUSHITA ELECTRIC INDUSTRIAL CO., LTD., Kadoma-shi, Osaka-fu, 571 (JP)
(72) Inventor: Nakatsuka, Tadayoshi, Osaka-shi, Osaka 533 (JP)
(74) Representative: Grünecker, Kinkeldey, Stockmair & Schwanhäusser Anwaltssozietät

(57) **Abstract**

There are disposed (i) a signal transmission passage extending, on the top surface of a ceramic supporting substrate, from one end to the other end thereof, (ii) a grounding electrode on the entire top surface of the supporting substrate except for its portion where the signal transmission passage is disposed and for its portion adjacent to the first-mentioned portion, and (iii) a detecting electrode at the underside of the one end of the supporting substrate. A microstrip line is formed by the signal transmission passage and those portions of the grounding electrode which are opposite to each other with the signal transmission passage held therebetween. Each of the grounding electrode, the signal transmission passage and the detecting electrode is made of an alloy containing 90 % or more of gold. The signal transmission passage and the detecting electrode are electrically connected to each other by an alloy of the type above-mentioned through a through-hole formed in the supporting substrate at the one end thereof.

## Description

### Background of the Invention

The present invention relates to an inspection apparatus for inspecting the high frequency characteristics of a high frequency semiconductor device, an inspection method of inspecting a high frequency semiconductor device with the use of the inspection apparatus above-mentioned, and a high frequency semiconductor device to be inspected with the inspection apparatus above-mentioned.

With the recent general spread of high frequency machinery and tools, there is increased a demand for a high frequency semiconductor device used in such machinery and tools. Therefore, it is of urgent necessity to establish a method of inspecting such a high frequency semiconductor device.

The following description will discuss an example of a conventional method of inspecting a high frequency semiconductor device with reference to attached drawings.

First, there is discussed the arrangement of a high frequency amplifying circuit to which such a conventional inspecting method is applied.

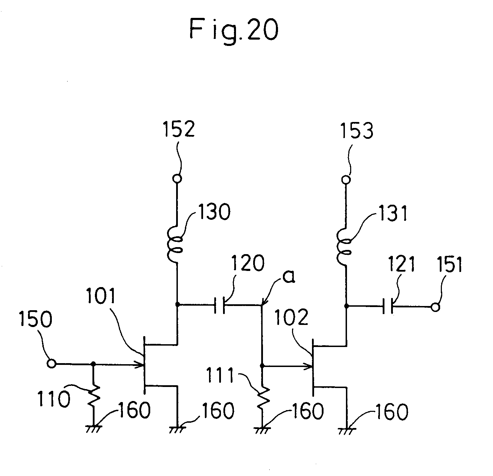

Fig. 20 shows the high frequency amplifying circuit above-mentioned, which has field-effect transistors (hereinafter referred to as FETs) 101, 102, and resistors 110, 111. By the resistors 110, 111, the gate-source bias voltages of the FETs 101, 102 are set to 0 V. Capacitors 120, 121 are disposed for interrupting a low frequency component and a direct current component of a signal, thereby to transmit only a high frequency component thereof. Inductors 130, 131 are disposed for giving a direct current to the FETs 101, 102 and for preventing a high frequency signal (RF signal) from escaping to the power source side. There are also disposed an RF signal input terminal 150, an RF signal output terminal 151, power source terminals 152, 153, and grounding terminals 160. In Fig. 20, the high frequency amplifying circuit is roughly divided by a point a into two portions, i.e., a front-stage block which is located in the left hand with respect to the point a and a rear-stage block which is located in the right hand with respect to the point a.

The following description will discuss the operation of the high frequency amplifying circuit having the arrangement above-mentioned.

As a power voltage, 5.0 V is given to the power source terminals 152, 153 so that an electric current is supplied to the FETs 101, 102. In the FETs 101, 102, the gate-source bias voltages are fixed to 0 V by the resistors 110, 111. When an RF signal is entered from the RF signal input terminal 150, the RF signal is amplified by the FET 101, and sent to the next-stage FET 102 through the capacitor 120. The RF signal is then amplified by the FET 102, and supplied from the output terminal 151 through the capacitor 121.

The following description will discuss a high frequency semiconductor device having, on a semiconductor substrate, the high frequency amplifying circuit having the arrangement above-mentioned.

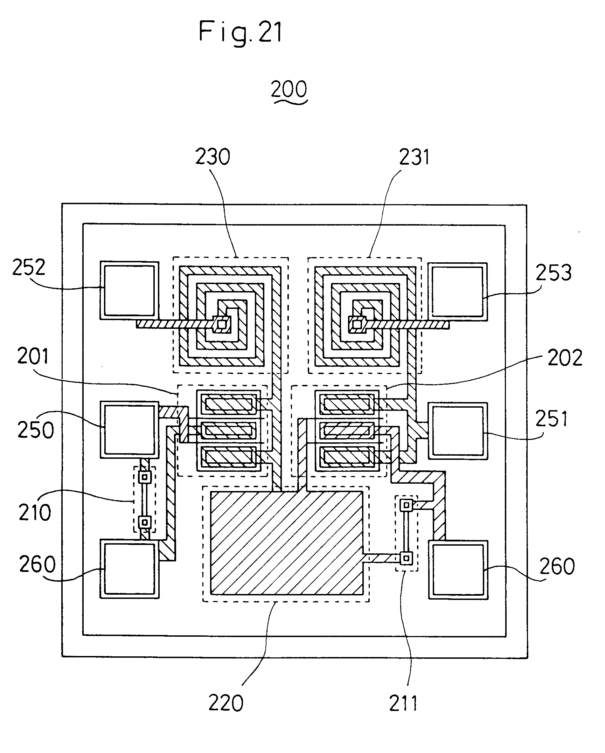

Fig. 21 shows a high frequency semiconductor device 200 of the type above-mentioned. Shown in Fig. 21 are a FET 201 corresponding to the FET 101 shown in Fig. 20, a FET 202 corresponding to the FET 102, a resistor 210 corresponding to the resistor 110, a resistor 211 corresponding to the resistor 111, a capacitor 220 corresponding to the capacitor 120, an inductor 230 corresponding to the inductor 130, and an inductor 231 corresponding to the inductor 131. There are also disposed an input pad 250 corresponding to the RF signal input terminal 150 shown in Fig. 20, an output pad 251 corresponding to the RF signal output terminal 151, power source pads 252, 253 corresponding to the power source terminals 152, 153, and grounding pads 260 corresponding to the grounding terminals 160. The capacitor 220 is an MIM (Metal Insulator Metal) capacitor formed by a first wiring metallic layer formed on the semiconductor substrate, an insulator layer formed on the first wiring metallic layer and a second wiring metallic layer formed on the insulator layer. The second wiring metallic layer serves as an upper electrode.

The following description will discuss a conventional method of inspecting the high frequency semiconductor device 200 having the arrangement above-mentioned.

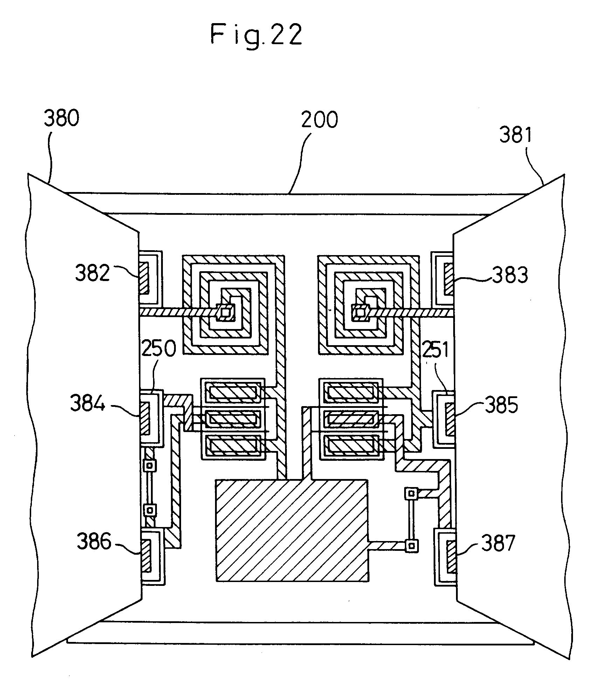

Fig. 22 shows a conventional RF inspection method of inspecting the high frequency semiconductor device 200. In Fig. 22, probes 380, 381 are high frequency measuring probes manufactured by Cascade Microtech (hereinafter referred to simply as high frequency probes). The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. The high frequency probes 380, 381 are designed such that a characteristic impedance of 50 Ω is held up to the tips thereof.

The input/output characteristics of the entire high frequency amplifying circuit of the high frequency semiconductor device 200 can be accurately evaluated in the following manner. The respective electrodes of the high frequency probes 380, 381 are contacted with the corresponding pads of the high frequency semiconductor device 200, a signal is entered from the input contact electrode 384 of the high frequency probe 380 into the input pad 250 of the high frequency semiconductor device 200, a signal supplied from the output pad 251 of the high frequency semiconductor device 200 is received by the output contact electrode 385 of the high frequency probe 381, and the signal from the output pad 251 is measured.

In the conventional inspection method above-mentioned, however, the characteristics of the entire circuit of the semiconductor device can be evaluated, but the characteristics of each block or the characteristics of each FET cannot disadvantageously be evaluated.

To solve the problem above-mentioned, there can be proposed, for example, a method in which a pad is connected to that portion of the high frequency semiconductor device 200 which corresponds to the point a in Fig. 20, and the electrode of a high frequency probe is contacted with the pad, thereby to evaluate the characteristics of each block.

However, the inspection method above-mentioned presents the problem that since the pad itself has great floating capacity, an influence is exerted to the characteristics of the entire circuit of the semiconductor device, failing to achieve an accurate measurement.

### Disclosure of the Invention

In view of the foregoing, the present invention is proposed with the object of providing an inspection apparatus for and an inspection method of accurately inspecting the characteristics of respective parts of the circuit of a semiconductor device, and also providing a semiconductor device to be suitably inspected with the inspection apparatus above-mentioned or by the inspection method above-mentioned.

To achieve the object above-mentioned, a first inspection apparatus according to the present invention comprises: an insulator substrate made of a material having a high dielectric constant; a signal transmission passage made of an electrically conductive material and formed on the top surface of the insulator substrate; a grounding electrode made of an electrically conductive material and formed at least on the top surfaces of those portions of the insulator substrate which are opposite to each other with another portion of the insulator substrate where the signal transmission passage is disposed held therebetween; a microstrip line formed by the signal transmission passage and those portions of the grounding electrode which are opposite to each other with the signal transmission passage held therebetween; and a detecting electrode made of an electrically conductive material and formed at the underside of the insulator substrate, the detecting electrode being electrically connected to the signal transmission passage through a through-hole formed in the insulator substrate.

According to the arrangement above-mentioned, for example, when the detecting electrode is contacted with an insulator protective layer on an MIM capacitor of a semiconductor device, the detecting electrode, the insulator protective layer and an upper metallic layer of the MIM capacitor serve as a capacitor, so that the detecting electrode can receive a high frequency signal from the MIM capacitor. Also, the detecting electrode can supply a high frequency signal to the MIM capacitor of the semiconductor device. It is therefore possible to inspect the characteristics of each of the blocks and FETs of the circuit of the semiconductor device. Further, by matching the characteristic impedance of the microstrip line with the characteristic impedance of a measuring system, high frequency signals at connection parts of the circuit of the semiconductor device can accurately be measured. Accordingly, the semiconductor device inspection precision can be enhanced.

In the first inspection apparatus, the signal transmission passage may be divided into first, second and third partial transmission passages, and the microstrip line may have (i) a capacitor having one electrode electrically connected to the first partial transmission passage and the other electrode electrically connected to the second partial transmission passage, and (ii) a transistor of which each electrode is electrically connected, by wire bonding, to the grounding electrode, the second partial transmission passage or the third partial transmission passage, the transistor being adapted to amplify a high frequency signal. According to the arrangement above-mentioned, the capacitor is connected in series to the inside of the signal transmission passage, and the high frequency amplifying transistor is connected, by wire bonding, to the grounding electrode and the signal transmission passage. Thus, a high frequency signal detected by the detecting electrode can be amplified in the microstrip line. This enables even a weak signal to be accurately detected.

In the first inspection apparatus, the signal transmission passage may be divided into first, second and third partial transmission passages, and the microstrip line may have (i) a capacitor having one electrode electrically connected to the first partial transmission passage and the other electrode electrically connected to the second partial transmission passage, and (ii) a transistor of which each electrode is electrically connected, by flip chip bonding, to the grounding electrode, the second partial transmission passage or the third partial transmission passage, the transistor being adapted to amplify a high frequency signal. According to the arrangement above-mentioned, the capacitor is connected in series to the inside of the signal transmission passage, and the high frequency amplifying transistor is connected, by flip chip bonding, to the grounding electrode and the signal transmission passage. Thus, there can be achieved an inspection apparatus excellent in high frequency characteristics with no influence exerted by bonding wires.

According to the present invention, each of the one and the other electrodes of the capacitor may comprise a metallic layer, and the capacitor may be an MIM capacitor comprising the metallic layers and an insulator layer made of a material having a high dielectric constant and interposed between the metallic layers. According to the arrangement above-mentioned, there can be achieved an inspection apparatus excellent in frequency characteristics.

To achieve the object above-mentioned, a second inspection apparatus according to the present invention, comprises: an insulator substrate made of a material having a high dielectric constant; a signal transmission passage made of an electrically conductive material and formed inside of the insulator substrate; a detecting electrode made of an electrically conductive material and formed at the underside of the insulator substrate, the detecting electrode being electrically connected to the signal transmission passage through an introduction hole which is formed in the insulator substrate and which extends from the underside to the inside thereof; a first grounding electrode made of an electrically conductive material and formed on the entire top surface of the insulator substrate; and a second grounding electrode made of an electrically conductive material and formed at the entire underside of the insulator substrate except for its portion where the detecting electrode is disposed and for its portion adjacent to the first-mentioned portion.

According to the arrangement above-mentioned, for example, when the detecting electrode is contacted with an insulator protective layer on an MIM capacitor of a semiconductor device, the detecting electrode, the insulator protective layer and an upper metallic layer of the MIM capacitor serve as a capacitor, so that the detecting electrode can receive a high frequency signal from the MIM capacitor. Also, the detecting electrode can supply a high frequency signal to the MIM capacitor of the semiconductor device. It is therefore possible to inspect the characteristics of each of the blocks and FETs of the circuit of the semiconductor device. Further, the first and second grounding electrodes at the top and underside of the insulator substrate prevent a noise signal from entering into the signal transmission passage from the outside of the second inspection apparatus. This increases the purity of a signal entered in or supplied from the detecting electrode, thus enhancing the semiconductor device inspection precision.

In the second inspection apparatus, the signal transmission passage may be divided into first, second and third partial transmission passages, and the inspection apparatus may comprise: a capacitor having one electrode electrically connected to the first partial transmission passage and the other electrode electrically connected to the second partial transmission passage; and a transistor of which each electrode is electrically connected, by wire bonding, to the first grounding electrode, the second grounding electrode, the second partial transmission passage or the third partial transmission passage, the transistor being adapted to amplify a high frequency signal. According to the arrangement above-mentioned, the capacitor is connected in series to the inside of the signal transmission passage, and the high frequency amplifying transistor is connected, by wire bonding, to the first and second grounding electrodes and the signal transmission passage. Thus, a high frequency signal detected by the detecting electrode can be amplified. This enables even a weak signal to be accurately detected.

In the second inspection apparatus, the signal transmission passage may be divided into first, second and third partial transmission passages, and the inspection apparatus may further comprise: a capacitor having one electrode electrically connected to the first partial transmission passage and the other electrode electrically connected to the second partial transmission passage; and a transistor of which each electrode is electrically connected, by flip chip bonding, to the first grounding electrode, the second grounding electrode, the second partial transmission passage or the third partial transmission passage, the transistor being adapted to amplify a high frequency signal. According to the arrangement above-mentioned, the capacitor is connected in series to the inside of the signal transmission passage, and the high frequency amplifying transistor is connected, by flip chip bonding, to the first and second grounding electrodes and the signal transmission passage. Thus, there can be achieved an inspection apparatus excellent in high frequency characteristics with no influence exerted by bonding wires.

To achieve the object above-mentioned, the present invention provides a first semiconductor device comprising: an MIM capacitor having a first metallic layer formed on a semiconductor substrate, an insulator layer formed on the first metallic layer and a second metallic layer formed on the insulator layer; an insulator protective layer formed on the MIM capacitor; and an electrical conductor layer made of an electrically conductive material and formed on the insulator protective layer.

According to the arrangement above-mentioned, the second metallic layer of the MIM capacitor, the insulator protective layer on the second metallic layer and the electrical conductor layer on the insulator protective layer form a capacitor. Accordingly, when inspecting the characteristics of the first semiconductor device, a stable signal value can be obtained to improve the inspection in accuracy.

A second semiconductor device according to the present invention comprises: a wiring layer formed on a semiconductor substrate; an insulator protective layer formed on the wiring layer; and an electrical conductor layer made of an electrically conductive material and formed on the insulator protective layer.

According to the arrangement above-mentioned, the wiring layer, the insulator protective layer on the wiring layer and the electrical conductor layer on the insulator protective layer form a capacitor. Accordingly, when inspecting the characteristics of the second semiconductor device, a stable signal value can be obtained to improve the inspection in accuracy.

To achieve the object above-mentioned, the present invention provides a first inspection method of inspecting a semiconductor device with the use of the first or second inspection apparatus according to the present invention, in which the semiconductor device comprises (i) an MIM capacitor having a first metallic layer formed on a semiconductor substrate, an insulator layer formed on the first metallic layer and a second metallic layer formed on the insulator layer, and (ii) an insulator protective layer formed on the MIM capacitor, and in which, with the detecting electrode of the inspection apparatus brought close to or contacted with the insulator protective layer of the semiconductor device, the detecting electrode of the inspection apparatus is adapted to supply or receive a high frequency signal to or from the MIM capacitor of the semiconductor device, so that the high frequency characteristics of the semiconductor device are inspected.

According to the arrangement above-mentioned, when the detecting electrode of the inspection apparatus is brought close to or contacted with the insulator protective layer on the MIM capacitor of the semiconductor device, the detecting electrode, the insulator protective layer and the second metallic layer of the MIM capacitor form a capacitor. This enables a high frequency signal to be transmitted between the circuit of the semiconductor device and the detecting electrode of the inspection apparatus. In such a state, the detecting electrode of the inspection apparatus can supply or receive a high frequency signal to or from the MIM capacitor of the semiconductor device, so that the high frequency characteristics of the respective portions of the circuit of the semiconductor device can be inspected.

The present invention also provides a second inspection method of inspecting a semiconductor device with the use of the first or second inspection apparatus according to the present invention, in which the semiconductor device comprises a wiring layer formed on a semiconductor substrate and an insulator protective layer formed on the wiring layer, and in which, with the detecting electrode of the inspection apparatus brought close to or contacted with the insulator protective layer of the semiconductor device, the detecting electrode of the inspection apparatus is adapted to supply or receive a high frequency signal to or from the wiring layer of the semiconductor device, so that the high frequency characteristics of the semiconductor device are inspected.

According to the arrangement above-mentioned, when the detecting electrode of the inspection apparatus is brought close to or contacted with the insulator protective layer on the wiring layer of the semiconductor device, the detecting electrode, the insulator protective layer and the wiring layer form a capacitor. This enables a high frequency signal to be transmitted between the circuit of the semiconductor device and the detecting electrode of the inspection apparatus. In such a state, the detecting electrode of the inspection apparatus can supply or receive a high frequency signal to or from the wiring layer of the semiconductor device, so that the high frequency characteristics of the respective portions of the circuit of the semiconductor device can be inspected.

The present invention also provides a third inspection method of inspecting the first semiconductor device according to the present invention with the use of the first or second inspection apparatus according to the present invention, in which, with the detecting electrode of the inspection apparatus brought close to or contacted with the electrical conductor layer of the first semiconductor device, the detecting electrode of the inspection apparatus is adapted to supply or receive a high frequency signal to or from the MIM capacitor of the first semiconductor device, so that the high frequency characteristics of the first semiconductor device are inspected.

The present invention also provides a fourth inspection method of inspecting the second semiconductor device according to the present invention with the use of the first or second inspection apparatus according to the present invention, in which, with the detecting electrode of the inspection apparatus brought close to or contacted with the electrical conductor layer of the second semiconductor device, the detecting electrode of the inspection apparatus is adapted to supply or receive a high frequency signal to or from the wiring layer of the second semiconductor device, so that the high frequency characteristics of the second semiconductor device are inspected.

According to each of the third and fourth inspection methods above-mentioned, it is possible to reduce a measurement error resulting from positional shift of the detecting electrode of the inspection apparatus by bringing or contacting the detecting electrode close to or with the electrical conductor layer on the insulator protective layer of the first or second semiconductor device. Further, the detecting electrode of the inspection apparatus can be reduced in wear as compared with a method in which the detecting electrode is contacted directly with the insulator protective layer of the semiconductor device.

### Brief Description of the Drawings

Figure 1 (a) is a plan view of an inspection apparatus according to a first embodiment of the present invention;
Figure 1 (b) is a section view of the inspection apparatus according to the first embodiment;
Figure 2 is a plan view of an inspection apparatus and a semiconductor device, illustrating an inspection method according to the first embodiment of the present invention;
Figure 3 is a section view of the inspection apparatus and the semiconductor device, illustrating the inspection method according to the first embodiment;
Figure 4 is a circuit diagram of a semiconductor device to which applied is an inspection method according to a second embodiment of the present invention;
Figure 5 is a plan view of the semiconductor device to which applied is the inspection method according to the second embodiment;
Figure 6 is a plan view of an inspection apparatus and a semiconductor device, illustrating the inspection method according to the second embodiment;
Figure 7 (a) is a plan view of an inspection apparatus according to a third embodiment of the present invention;
Figure 7 (b) is a section view of the inspection apparatus according to the third embodiment;
Figure 8 is a plan view of an inspection apparatus and a semiconductor device, illustrating the inspection method according to the third embodiment;
Figure 9 (a) is a plan view of an inspection apparatus according to a fourth embodiment of the present invention;
Figure 9 (b) is a section view of the inspection apparatus according to the fourth embodiment;
Figure 10 is a plan view of a transistor of the inspection apparatus according to the fourth embodiment;
Figure 11 is a plan view of a semiconductor device to which applied is an inspection method according to the fourth embodiment of the present invention;
Figure 12 is a plan view of an inspection apparatus and a semiconductor device, illustrating the inspection method according to the fourth embodiment;
Figure 13 (a) is a plan view of an inspection apparatus according to a fifth embodiment of the present invention;
Figure 13 (b) is a section view of the inspection apparatus according to the fifth embodiment;
Figure 14 is a plan view of a transistor of the inspection apparatus according to the fifth embodiment:
Figure 15 (a) is a plan view of an inspection apparatus according to a sixth embodiment of the present invention;
Figure 15 (b) is a section view of the inspection apparatus according to the sixth embodiment:
Figure 16 is a plan view of a semiconductor device according to a seventh embodiment of the present invention:
Figure 17 is a circuit diagram of the semiconductor device according to the seventh embodiment;
Figure 18 is a plan view of an inspection apparatus and a semiconductor device, illustrating an inspection method according to the seventh embodiment of the present invention:
Figure 19 is a section view of the inspection apparatus and the semiconductor device, illustrating the inspection method according to the seventh embodiment:
Figure 20 is a circuit diagram of a conventional semiconductor device;
Figure 21 is a plan view of the conventional semiconductor device; and
Figure 22 is a plan view of a semiconductor device and high frequency probes, illustrating a conventional inspection method.

### Detailed Description of the Invention

### (First Embodiment)

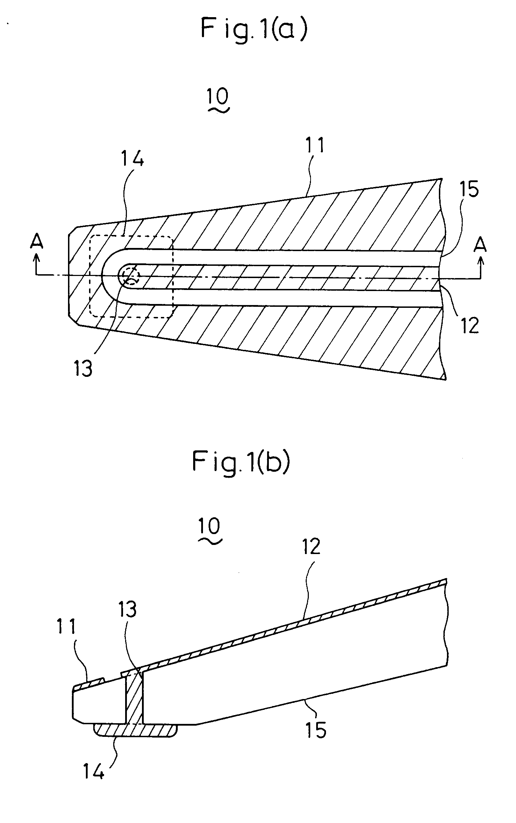

The following description will discuss an inspection apparatus and an inspection method according to a first embodiment of the present invention with reference to Fig. 1 (a), Fig. 1 (b), Fig. 2 and Fig. 3. In the following description, a semiconductor device to be inspected is similar to the high frequency semiconductor device 200 shown in Fig. 21.

First, the inspection apparatus according to the first embodiment will be discussed.

Fig. 1 (a) and Fig. 1 (b) show an inspection apparatus 10 according to the first embodiment. Fig. 1 (a) is a plan view, while Fig. 1 (b) is a section view taken along the line A-A in Fig. 1 (a). In Fig. 1 (a) and Fig. 1 (b), there are disposed a grounding electrode 11, a signal transmission passage 12, a through-hole 13, a detecting electrode 14 and a ceramic supporting substrate 15. The signal transmission passage 12 transversely extends over the top surface of the ceramic supporting substrate 15. The grounding electrode 11 is disposed on the entire top surface of the ceramic supporting substrate 15 except for its portion where the signal transmission passage 12 is disposed and for its portion adjacent to the first-mentioned portion. The detecting electrode 14 is disposed at the underside of the left-end portion of the ceramic supporting substrate 15, and a microstrip line is formed by the signal transmission passage 12 and those portions of the grounding electrode 11 which are opposite to each other with the signal transmission passage 12 held therebetween. Each of the grounding electrode 11, the signal transmission passage 12 and the detecting electrode 14 is made of an alloy containing 90 % or more of gold, and the detecting electrode 14 is improved in wear resistance in that the surface thereof is coated with a tungsten alloy of 20 µm in thickness. The signal transmission passage 12 and the detecting electrode 14 are connected to each other by an alloy of the type above-mentioned through the through-hole 13 formed in the left-end portion of the ceramic supporting substrate 15.

The following description will discuss the inspection method according to the first embodiment in which there is used the inspection apparatus 10 having the arrangement above-mentioned.

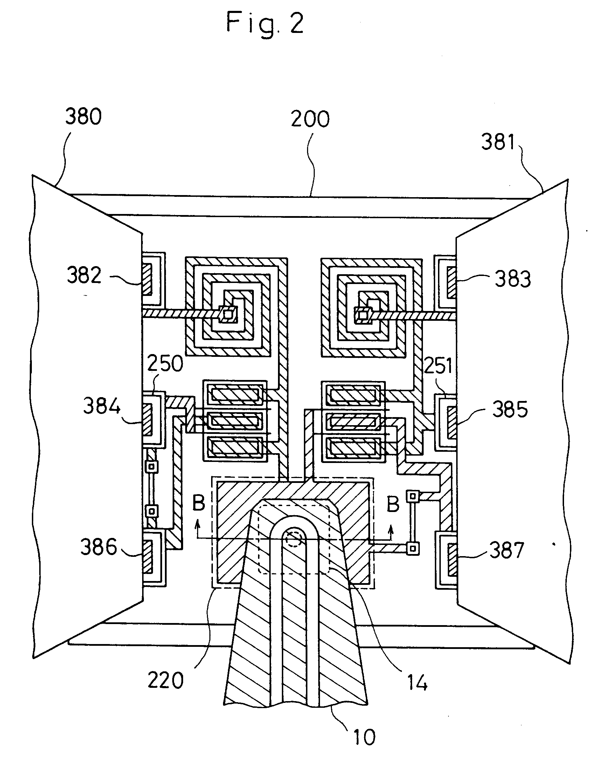

In Fig. 2 which shows the inspection method above-mentioned, there is shown an inspection apparatus 10 according to the first embodiment, having a detecting electrode 14. A high frequency semiconductor device 200 is similar to the device shown in Fig. 21 and has an MIM capacitor 220, an input pad 250 and an output pad 251. There are also shown high frequency probes 380, 381. The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. In Fig. 2, the input contact electrode 384 of the high frequency probe 380 is contacted with the input pad 250 of the high frequency semiconductor device 200, the output contact electrode 385 of the high frequency probe 381 is contacted with the output pad 251 of the high frequency semiconductor device 200, and the detecting electrode 14 of the inspection apparatus 10 is contacted with an insulator protective layer on a second wiring metallic layer serving as an upper electrode of the capacitor 220 of the high frequency semiconductor device 200.

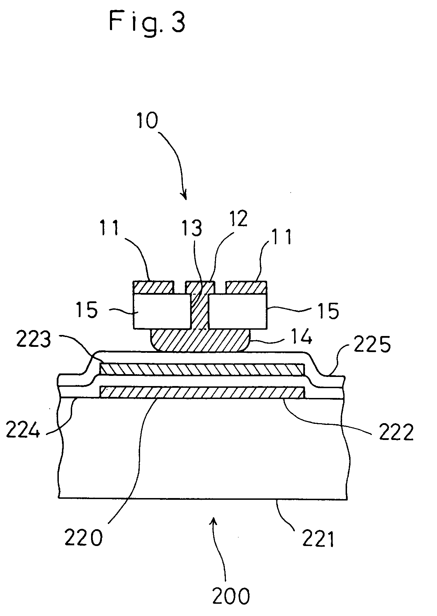

Fig. 3 is a section view taken along the line B-B in Fig. 2. In Fig. 3, there is shown the inspection apparatus 10 according to the first embodiment, which has a grounding electrode 11, a signal transmission passage 12, a through-hole 13, the detecting electrode 14 and a ceramic supporting substrate 15. A high frequency semiconductor device 200 is similar to the device shown in Fig. 21, and has a semiconductor substrate 221, a first wiring metallic layer 222 formed on the semiconductor substrate 221, an insulator layer 224 formed as extending from the first wiring metallic layer 222 onto the semiconductor substrate 221, a second wiring metallic layer 223 formed on the insulator layer 224, and an MIM capacitor 220 formed by (i) the first wiring metallic layer 222, (ii) the second wiring metallic layer 223 and (iii) that portion of the insulator layer 224 which is interposed between the first and second wiring metallic layers. An insulator protective layer 225 is formed as extending from the MIM capacitor 220 onto the insulator layer 224.

As shown in Figs. 2 and 3, the detecting electrode 14 of the inspection apparatus 10 is disposed on the insulator protective layer 225 on the second wiring metallic layer 223 of the high frequency semiconductor device 200. Accordingly, the second wiring metallic layer 223, the detecting electrode 14 and that portion of the insulator protective layer 225 interposed between the second wiring metallic layer 223 and the detecting electrode 14, serve as an MIM capacitor, and a portion of an RF signal electric power at that portion of the high frequency semiconductor device 200 which is opposite to the point a shown in Fig. 20, is supplied to the detecting electrode 14 of the inspection apparatus 10. At this time, by measuring the RF signal electric power transmitted to the detecting electrode 14 of the inspection apparatus 10, there can be obtained the characteristics of the front-stage block of the high frequency amplifying circuit in the high frequency semiconductor device 200. On the other hand, there can be obtained the characteristics of the rear-stage block of the high frequency amplifying circuit when an RF signal is entered from the detecting electrode 14 of the inspection apparatus 10 into the MIM capacitor 220 of the high frequency semiconductor device 200 and the RF signal electric power at the output pad 251 of the high frequency semiconductor device 200 is measured with the operation of the front-stage block of the high frequency amplifying circuit stopped.

In the inspection apparatus 10 and the inspection method according to the first embodiment as discussed in the foregoing, the detecting electrode 14 is contacted with the insulator protective layer 225 on the MIM capacitor 220 in the high frequency semiconductor device 200, so that the detecting electrode 14, the insulator protective layer 225 and the second wiring metallic layer 223 of the MIM capacitor 220, serve as a capacitor, and the detecting electrode 14 can therefore receive the RF signal from the MIM capacitor 220. On the contrary, an RF signal can be supplied from the detecting electrode 14 to the MIM capacitor 220 of the high frequency semiconductor device 200. It is therefore possible to inspect the characteristics of each of the blocks forming the high frequency amplifying circuit of the high frequency semiconductor device 200. Further, when the characteristic impedance of the microstrip line is matched with the characteristic impedance of the measuring system, there can be accurately measured the RF signal at each connection part in the high frequency amplifying circuit of the high frequency semiconductor device 200. This improves the precision at which the high frequency semiconductor device 200 is inspected.

### (Second Embodiment)

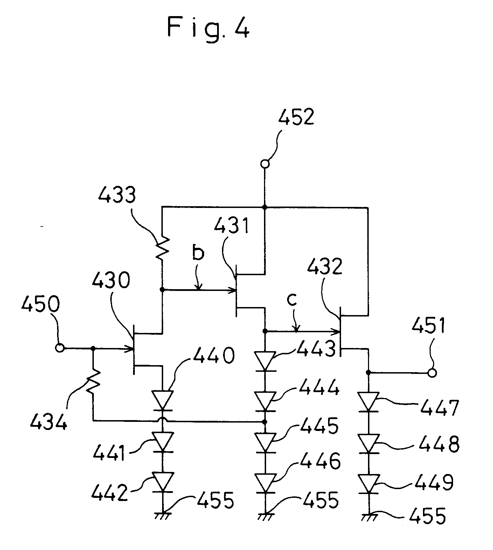

The following description will discuss an inspection method according to a second embodiment of the present invention with reference to Figs. 4, 5, 6. As an inspection apparatus, there is used apparatus similar to the inspection apparatus 10 according to the first embodiment shown in Fig. 1 (a) and Fig. 1 (b).

First, there is discussed a high frequency semiconductor device to which applied is the inspection method according to the second embodiment.

Fig. 4 shows a high frequency amplifying circuit of the high frequency semiconductor device above-mentioned. Shown in Fig. 4 are FETs 430, 431, 432, resistors 433, 434, diodes 440 to 449, an RF signal input terminal 450, an RF signal output terminal 451, a power source terminal 452, and grounding terminals 455.

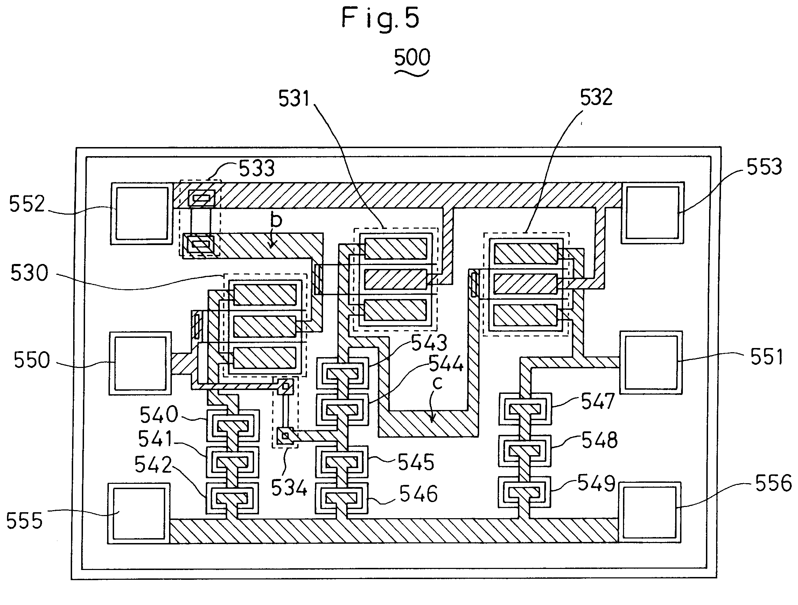

In Fig. 4, 5.0 V is given, as a power voltage, to the power source terminal 452, so that an electric current is supplied to the FETs 430 to 432. The respective FETs are designed such that the gate bias voltages are set to the optimum values by the resistor 433 and the diodes 440 to 449. When an RF signal is entered from the RF signal input terminal 450, the RF signal is amplified by the FET 430, and sent to the next-stage FET 431. The FET 431 has a source follower arrangement and serves as an output buffer. The FET 431 transmits the RF signal to the next-stage FET 432 and returns a portion of the RF signal back to the first-stage FET 430 through the resistor 434. Thus, a feedback circuit is formed, enabling the high frequency amplifying circuit to be stabilized. The last-stage FET 432 serves as a buffer circuit of a source follower arrangement for restraining an influence of a circuit at the subsequent stage.

Fig. 5 shows a high frequency semiconductor device 500 of the type above-mentioned. Shown in Fig. 5 are a FET 530 corresponding to the FET 430 shown in Fig. 4, a FET 531 corresponding to the FET 431, a FET 532 corresponding to the FET 432, a resistor 533 corresponding to the resistor 433, a resistor 534 corresponding to the resistor 434, and diodes 540 to 549 corresponding to the diodes 440 to 449. There are also disposed an input pad 550 corresponding to the RF signal input terminal 450 shown in Fig. 4, an output pad 551 corresponding to the RF signal output terminal 451, power source pads 552, 553 corresponding to the power source terminal 452, and grounding pads 555, 556 corresponding to the grounding terminals 455. Each of portions b and c in Fig. 5 is formed by a second wiring metallic layer and has a width equal to 30 µm which is three times or more as wide as the normal width.

The following description will discuss the second inspection method of inspecting the high frequency semiconductor device 500 having the arrangement above-mentioned.

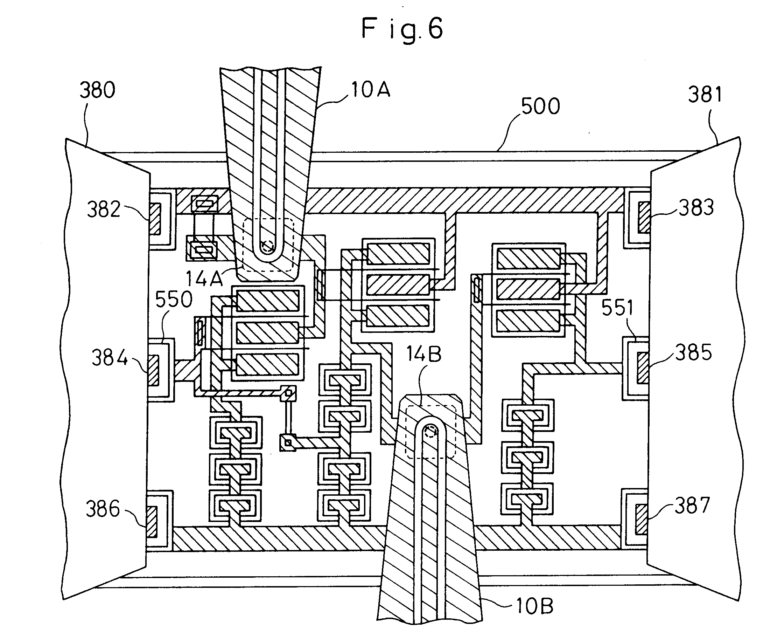

In Fig. 6 which shows the inspection method above-mentioned, there are shown inspection apparatus 10A, 10B each of which is similar to the inspection apparatus 10 according to the first embodiment shown in Fig. 1 (a) and Fig. 1 (b), detecting electrodes 14A, 14B of the respective inspection apparatus 10A, 10B, and a high frequency semiconductor device 500 which has been shown in Fig. 5. There are also shown an input pad 550, an output pad 551, and high frequency probes 380, 381. The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. In Fig. 6, the input contact electrode 384 of the high frequency probe 380 is contacted with the input pad 550 of the high frequency semiconductor device 500, the output contact electrode 385 of the high frequency probe 381 is contacted with the output pad 551 of the high frequency semiconductor device 500, and the detecting electrode 14A of the inspection apparatus 10A is contacted with an insulator protective layer on the portion b of the second wiring metallic layer of the high frequency semiconductor device 500, and the detecting electrode 14B of the inspection apparatus 10B is contacted with the insulator protective layer on the portion c of the second wiring metallic layer of the high frequency semiconductor device 500.

As shown in Fig. 6, the detecting electrode 14A of the inspection apparatus 10A is disposed on the insulator protective layer on the portion b of the second wiring metallic layer of the high frequency semiconductor device 500, and the detecting electrode 14B of the inspection apparatus 10B is disposed on the insulator protective layer on the portion c of the second wiring metallic layer of the high frequency semiconductor device 500. Accordingly, (i) the portion b of the second wiring metallic layer of the high frequency semiconductor device 500, (ii) the detecting electrode 14A of the inspection apparatus 10A, and (iii) that portion of the insulator protective layer of the high frequency semiconductor device 500 which is interposed between the point b of the second wiring metallic layer and the detecting electrode 14A of the inspection apparatus 10A, serve as an MIM capacitor. Also, (i) the portion c of the second wiring metallic layer of the high frequency semiconductor device 500, (ii) the detecting electrode 14B of the inspection apparatus 10B and (iii) that portion of the insulator protective layer of the high frequency semiconductor device 500 which is interposed between the point c of the second wiring metallic layer and the detecting electrode 14B of the inspection apparatus 10B, serve as an MIM capacitor. When a signal is entered into the input pad 550 of the high frequency semiconductor device 500 from the input contact electrode 384 of the high frequency probe 380, a portion of an RF signal electric power at the portion b of the high frequency semiconductor device 500, is supplied to the detecting electrode 14A of the inspection apparatus 10A. At this time, by measuring the RF signal electric power, there can be obtained the characteristics of the front-stage block of the high frequency amplifying circuit of the high frequency semiconductor device 500. On the other hand, when an RF signal is entered from the detecting electrode 14A of the inspection apparatus 10A into the portion b of the high frequency semiconductor device 500, a portion of the RF signal electric power at the portion c of the high frequency semiconductor device 500 is received by the detecting electrode 14B of the inspection apparatus 10B, and the RF signal electric power is measured, there can be obtained the characteristics of the intermediate-stage block of the high frequency amplifying circuit of the high frequency semiconductor device 500. Further, when an RF signal is entered from the detecting electrode 14B of the inspection apparatus 10B into the portion c of the high frequency semiconductor device 500 and the RF signal electric power at the output pad 551 of the high frequency semiconductor device 500 is measured, there can be obtained the characteristics of the rear-stage block of the high frequency amplifying circuit of the high frequency semiconductor device 500.

In the inspection method according to the second embodiment above-mentioned, the detecting electrodes 14A, 14B of the inspection apparatus 10A, 10B are disposed on the insulator protective layer on the second wiring metallic layer of the high frequency semiconductor device 500. Accordingly, the detecting electrodes, the insulator protective layer and the second wiring metallic layer form the respective capacitors. This enables a high frequency signal to be transmitted between the high frequency amplifying circuit of the high frequency semiconductor device 500 and each of the inspection apparatus 10A, 10B. It is therefore possible to inspect the characteristics of each of the portions of the high frequency amplifying circuit of the high frequency semiconductor device 500 when an RF signal is supplied from the detecting electrode of any of the inspection apparatus into the second wiring metallic layer of the high frequency semiconductor device 500, or when an RF signal from the second wiring metallic layer of the high frequency semiconductor device 500 is received by the detecting electrode of any of the inspection apparatus.

### (Third Embodiment)

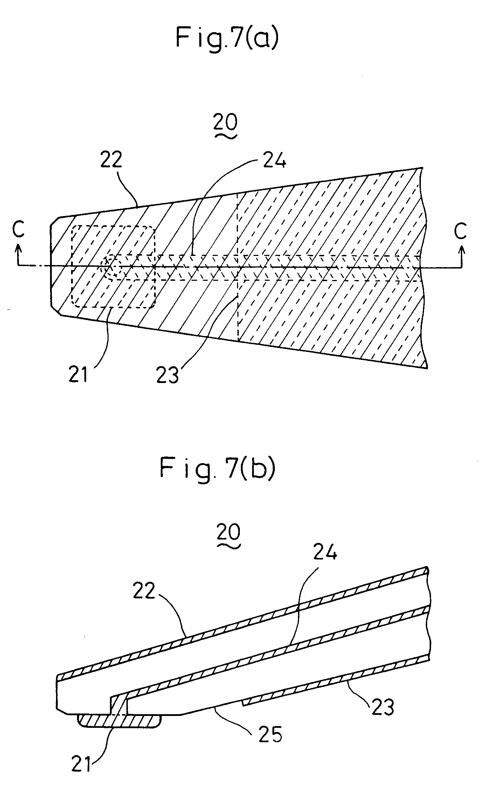

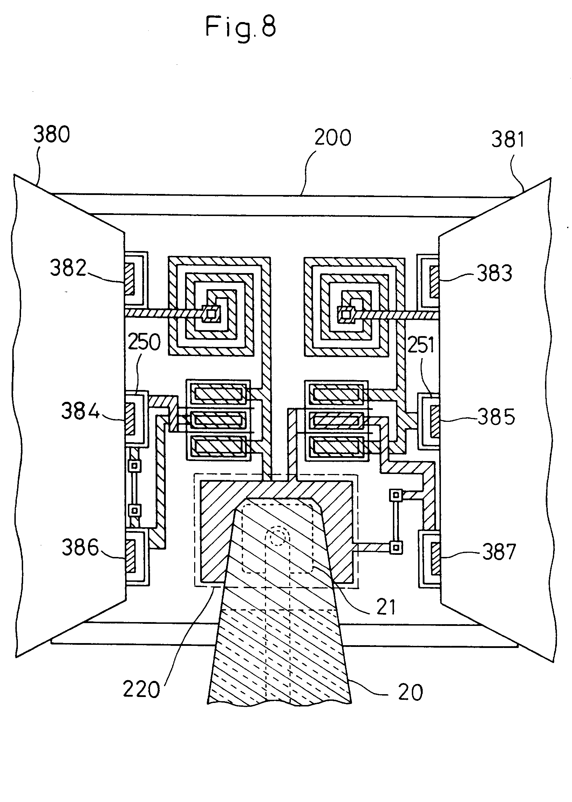

The following description will discuss an inspection apparatus and an inspection method according to a third embodiment of the present invention with reference to Fig. 7 (a), Fig. 7 (b) and Fig. 8. In the following description, a semiconductor device to be inspected is similar to the high frequency semiconductor device 200 shown in Fig. 21.

First, the inspection apparatus according to the third embodiment will be discussed.

Fig. 7 (a) and Fig. 7 (b) show an inspection apparatus 20 of the third embodiment. Fig. 7 (a) is a plan view, while Fig. 7 (b) is a section view taken along the line C-C in Fig. 7 (a). In Fig. 7 (a) and Fig. 7 (b), there are disposed a detecting electrode 21, grounding electrodes 22, 23, a signal transmission passage 24 and a multi-layer ceramic supporting substrate 25. The signal transmission passage 24 transversely extends inside of the multi-layer ceramic supporting substrate 25. The detecting electrode 21 is disposed at the underside of the left-end portion of the multi-layer ceramic supporting substrate 25. The grounding electrode 22 is formed on the entire top surface of the multi-layer ceramic supporting substrate 25, and the grounding electrode 23 is formed at the entire underside of the multi-layer ceramic supporting substrate 25 except for its left-end portion. Each of the detecting electrode 21, the grounding electrodes 22, 23 and the signal transmission passage 24 is made of an alloy containing 90 % or more of gold, and the detecting electrode 21 is improved in wear resistance in that the surface thereof is coated with a tungsten alloy of 20 µm in thickness. The signal transmission passage 24 and the detecting electrode 21 are connected to each other by an alloy of the type above-mentioned through an introduction hole which is formed in the multi-layer ceramic supporting substrate 25 and which extends to the inside from the underside of the left-end portion of the multi-layer ceramic supporting substrate 25.

Fig. 8 shows the inspection method according to the third embodiment, using an inspection apparatus 20 having the arrangement above-mentioned. In Fig. 8, there are shown the inspection apparatus 20 according to the third embodiment, a detecting electrode 21, a high frequency semiconductor device 200 similar to the device shown in Fig. 21, an MIM capacitor 220, an input pad 250 and an output pad 251. There are also shown high frequency probes 380, 381. The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. In Fig. 8, the input contact electrode 384 of the high frequency probe 380 is contacted with the input pad 250 of the high frequency semiconductor device 200, the output contact electrode 385 of the high frequency probe 381 is contacted with the output pad 251 of the high frequency semiconductor device 200, and the detecting electrode 21 of the inspection apparatus 20 is contacted with an insulator protective layer on a second wiring metallic layer serving as an upper electrode of the capacitor 220 of the high frequency semiconductor device 200. The measuring principle in the third embodiment is similar to that in the first embodiment.

In the inspection apparatus 20 and the inspection method according to the third embodiment, the detecting electrode 21 of the inspection apparatus 20 is contacted with the insulator protective layer on the MIM capacitor 220 in the high frequency semiconductor device 200. Accordingly, the detecting electrode 21 of the inspection apparatus 20, the insulator protective layer of the high frequency semiconductor device 200 and the second wiring metallic layer of the MIM capacitor 220, serve as a capacitor. Therefore, the detecting electrode 21 of the inspection apparatus 20 can receive an RF signal from the MIM capacitor 220 of the high frequency semiconductor device 200. On the other hand, the detecting electrode 21 of the inspection apparatus 20 can supply an RF signal to the MIM capacitor 220 of the high frequency semiconductor device 200. It is therefore possible to inspect the characteristics of each of the FETs and blocks forming the high frequency amplifying circuit of the high frequency semiconductor device 200. Further, the grounding electrodes 22, 23 at the top and underside of the multilayer ceramic supporting substrate 25, prevent a noise signal from entering into the signal transmission passage 24 from the outside of the inspection apparatus 20. This increases the purity of signals entered to and supplied from the detecting electrode 21 of the inspection apparatus 20, thus improving the precision at which the high frequency semiconductor device 200 is inspected.

### (Fourth Embodiment)

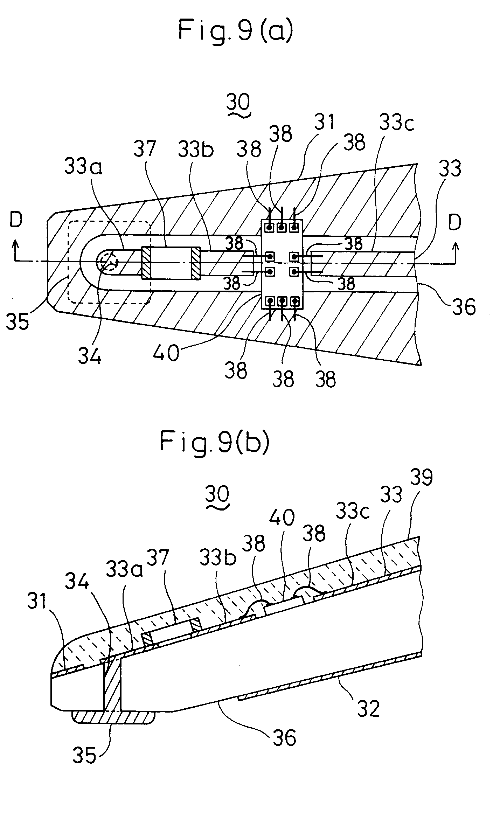

The following description will discuss an inspection apparatus and an inspection method according to a fourth embodiment of the present invention with reference to Fig. 9 (a), Fig. 9 (b) and Figs. 10 to 12.

First, the inspection apparatus according to the fourth embodiment will be discussed.

Fig. 9 (a) and Fig. 9 (b) show an inspection apparatus 30 of the fourth embodiment. Fig. 9 (a) is a plan view, while Fig. 9 (b) is a section view taken along the line D-D in Fig. 9 (a). In Fig. 9 (a) and Fig. 9 (b), there are disposed grounding electrodes 31, 32, a signal transmission passage 33, a through-hole 34, a detecting electrode 35, a ceramic supporting substrate 36, a chip condenser 37, a semiconductor chip 40, bonding wires 38 and a light-shielding resin 39. The signal transmission passage 33 transversely extends on the top surface of the ceramic supporting substrate 36 and is divided into three partial transmission passages 33a, 33b, 33c. The grounding electrode 31 is disposed on the entire top surface of the ceramic supporting substrate 36 except for its portion where the signal transmission passage 33 is disposed, and for its portion adjacent to the first-mentioned portion. The detecting electrode 35 is disposed at the underside of the left-end portion of the ceramic supporting substrate 36, and the grounding electrode 32 is disposed at the entire underside of the ceramic supporting substrate 36 except for its left-end portion. Each of the grounding electrodes 31, 32, the signal transmission passage 33 and the detecting electrode 35 is made of an alloy containing 90 % or more of gold, and the detecting electrode 35 is improved in wear resistance in that the surface thereof is coated with a tungsten alloy of 20 µm in thickness. The partial transmission passage 33a and the detecting electrode 35 are connected to each other by an alloy of the type above-mentioned through the through-hole 34 formed in the left-end portion of the ceramic supporting substrate 36. The chip condenser 37 has one electrode electrically connected to the partial transmission passage 33a, and the other electrode electrically connected to the partial transmission passage 33b.

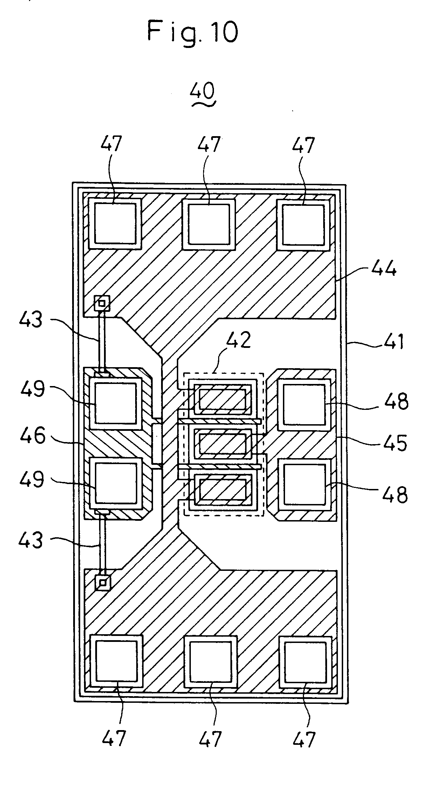

In Fig. 10 showing the semiconductor chip 40, there are shown a GaAs substrate 41, an FET 42, bias resistors 43, wiring metal 44 connected to the source electrode, wiring metal 45 connected to the drain electrode, wiring metal 46 connected to the gate electrode, source electrode pads 47, drain electrode pads 48, and gate electrode pads 49. In the GaAs FET, the gate width is equal to 100 µm, the chip sizes are 300 µm x 150 µm and the substrate thickness is 50 µm. The semiconductor chip 40 is bonded to the ceramic supporting substrate 36 shown in Fig. 9 (a) and Fig. 9 (b). The gate electrode pads 49 are connected to the partial transmission passage 33b by wire bonding, the drain electrode pads 48 are connected, by wire bonding, to the partial transmission passage 33c adapted to be connected to an instrument, and the source electrode pads 47 are connected to the grounding electrode 31 by wire bonding. With the arrangement above-mentioned, a signal detected by the detecting electrode 35 can be sent, as amplified by the semiconductor chip 40, to the instrument. The FET 42 is covered with the light-shielding resin 39 such that no influence is exerted to the FET 42 by external light.

The following description will discuss a high frequency semiconductor device to which applied is the inspection apparatus 30 having the arrangement above-mentioned.

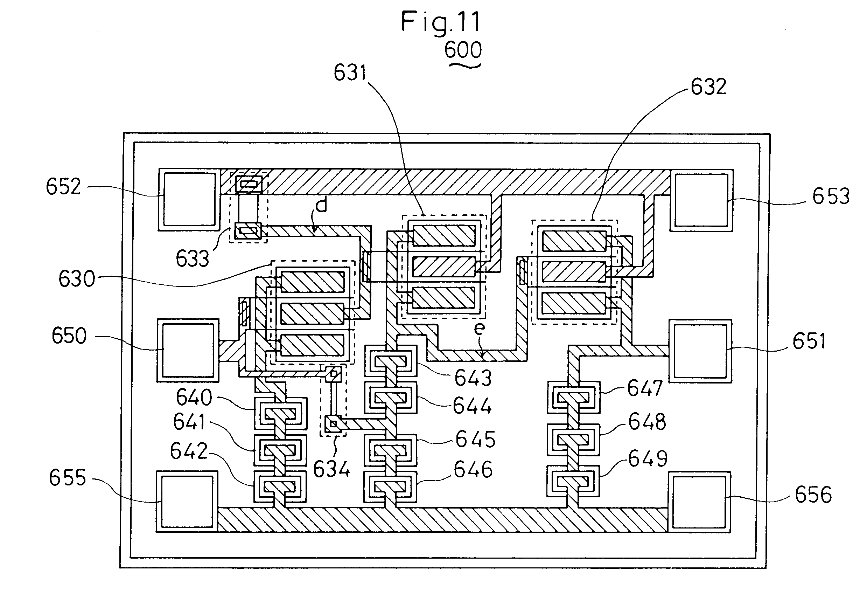

Fig. 11 shows a high frequency semiconductor device 600, which has the high frequency amplifying circuit shown in Fig. 4 formed in a usual wiring width on the semiconductor substrate thereof. Shown in Fig. 11 are FETs 630 to 632 corresponding to the FETs 430 to 432 shown in Fig. 4, resistors 633, 634 corresponding to the resistors 433; 434, diodes 640 to 649 corresponding to the diodes 440 to 449, an input pad 650 corresponding to the RF signal input terminal 450, an output pad 651 corresponding to the RF signal output terminal 451, power source pads 652, 653 corresponding to the power source terminal 452, and grounding pads 655 to 656 corresponding to the grounding terminals 455. In Fig. 11, each of portions d and e is formed by a second wiring metallic layer and has a usual wiring width of 10 µm.

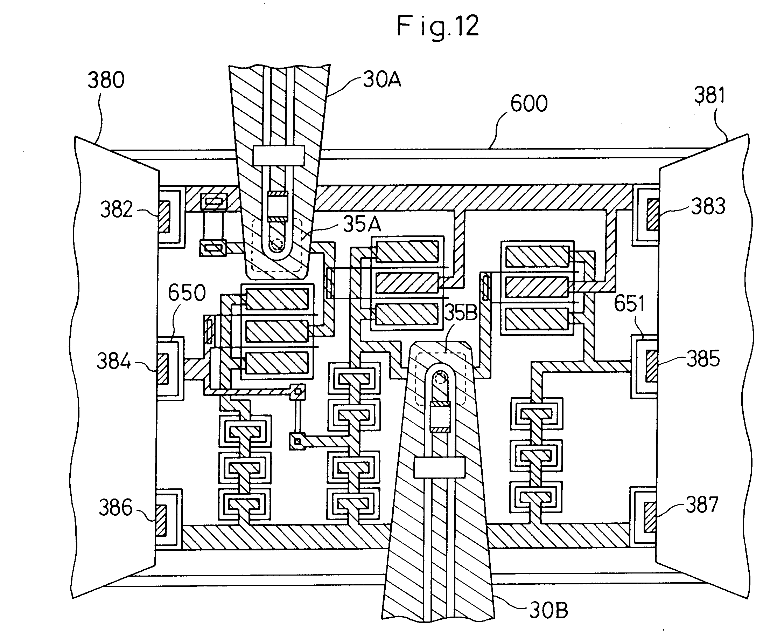

Fig. 12 shows the inspection method according to the fourth embodiment of inspecting the high frequency semiconductor device 600 having the arrangement above-mentioned. In Fig. 12, there are shown inspection apparatus 30A, 30B each of which is similar to the inspection apparatus 30 according to the fourth embodiment shown in Fig. 9 (a) and Fig. 9 (b), detecting electrodes 35A, 35B of the respective inspection apparatus 30A, 30B, and the high frequency semiconductor device 600 which has been shown in Fig. 11. There are also shown the input pad 650, the output pad 651, and high frequency probes 380, 381. The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. In Fig. 12, the input contact electrode 384 of the high frequency probe 380 is contacted with the input pad 650 of the high frequency semiconductor device 600, the output contact electrode 385 of the high frequency probe 381 is contacted with the output pad 651 of the high frequency semiconductor device 600, and the detecting electrode 35A of the inspection apparatus 30A is contacted with an insulator protective layer on the portion d of the second wiring metallic layer of the high frequency semiconductor device 600, and the detecting electrode 35B of the inspection apparatus 30B is contacted with the insulator protective layer on the portion e of the second wiring metallic layer of the high frequency semiconductor device 600. The measuring principle is similar to that in the second embodiment.

In the inspection apparatus 30 and the inspection method according to the fourth embodiment, the chip condenser 37 is connected in series to the inside of the signal transmission passage 33, and the semiconductor chip 40 is connected to the grounding electrode 31 and the signal transmission passage 33 by wire bonding. This enables a weak voltage signal to be amplified, thus producing a signal of which signal/noise ratio (S/N ratio) is high. It is therefore possible to detect a signal on a signal line having a usual wiring width in the high frequency semiconductor device 600.

### (Fifth Embodiment)

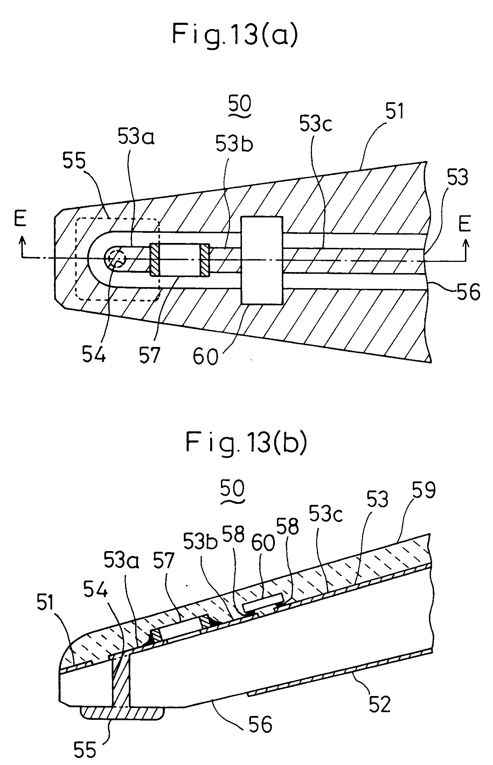

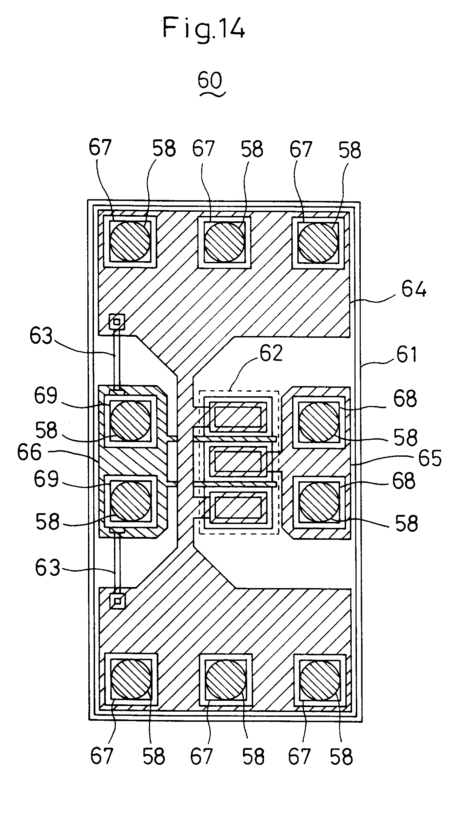

The following description will discuss an inspection apparatus according to a fifth embodiment of the present invention with reference to Fig. 13 (a), Fig. 13 (b) and Fig. 14.

Fig. 13 (a) and Fig. 13 (b) show an inspection apparatus 50 according to the fifth embodiment. Fig. 13 (a) is a plan view, while Fig. 13 (b) is a section view taken along the line E-E in Fig. 13 (a). In Fig. 13 (a) and Fig. 13 (b), there are disposed grounding electrodes 51, 52, a signal transmission passage 53, a through-hole 54, a detecting electrode 55, a ceramic supporting substrate 56, a chip condenser 57, a semiconductor chip 60, gold (Au) bumps 58, and a light-shielding resin 59. The signal transmission passage 53 transversely extends on the top surface of the ceramic supporting substrate 56 and is divided into three partial transmission passages 53a, 53b, 53c. The grounding electrode 51 is disposed on the entire top surface of the ceramic supporting substrate 56 except for its portion where the signal transmission passage 53 is disposed, and for its portion adjacent to the first-mentioned portion. The detecting electrode 55 is disposed at the underside of the left-end portion of the ceramic supporting substrate 56, and the grounding electrode 52 is disposed at the entire underside of the ceramic supporting substrate 56 except for its left-end portion. Each of the grounding electrodes 51, 52, the signal transmission passage 53 and the Au bumps 58 is made of an alloy containing 90 % or more of gold, and the detecting electrode 55 is improved in wear resistance in that the surface thereof is coated with a tungsten alloy of 20 µm in thickness. The partial transmission passage 53a and the detecting electrode 55 are connected to each other by an alloy of the type above-mentioned through the through-hole 54 formed in the left-end portion of the ceramic supporting substrate 56. The chip condenser 57 has one electrode electrically connected to the partial transmission passage 53a, and the other electrode electrically connected to the partial transmission passage 53b.

In Fig. 14 showing the semiconductor chip 60, there are disposed a GaAs substrate 61, an FET 62, bias resistors 63, wiring metal 64 connected to the source electrode, wiring metal 65 connected to the drain electrode, wiring metal 66 connected to the gate electrode, source electrode pads 67, drain electrode pads 68, gate electrode pads 69 and Au bumps 58 formed on the respective electrode pads. In the GaAs FET, the gate width is equal to 100 µm, the chip sizes are 300 µm x 150 µm and the substrate thickness is 50 µm. After the Au bumps 58 are formed on the respective electrode pads of the semiconductor chip 60, the semiconductor chip 60 is then turned over. Then, the semiconductor chip 60 is bonded, under pressure, to the ceramic supporting substrate 56 while making sure of the position of the semiconductor chip 60 such that the gate electrode pads 69 are connected to the partial transmission passage 53b by Au bumps 58, that the drain electrode pads 68 are connected, by Au bumps 58, to the partial transmission passage 53c adapted to be connected to an instrument, and that the source electrode pads 67 are connected to the grounding electrode 51 by Au bumps 58. The semiconductor chip 60 is covered with the light-shielding resin 59 such that no influence is exerted to the chip 60 by external light.

In the inspection apparatus 50 according to the fifth embodiment, the chip condenser 57 is connected in series to the inside of the signal transmission passage 53, and the semiconductor chip 60 is connected to the grounding electrode 51 and the signal transmission passage 53 by flip chip bonding. Thus, there can be provided an inspection apparatus excellent in high frequency characteristics with no influence exerted by bonding wires.

### (Sixth Embodiment)

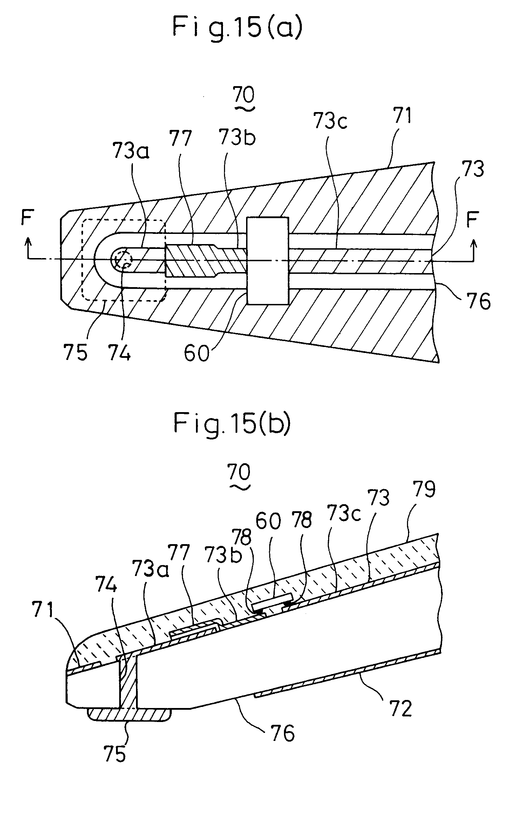

The following description will discuss an inspection apparatus according to a sixth embodiment of the present invention with reference to Fig. 15 (a) and Fig. 15 (b). Fig. 15 (a) and Fig. 15 (b) show an inspection apparatus 70 according to the sixth embodiment. Fig. 15 (a) is a plan view, while Fig. 15 (b) is a section view taken along the line F-F in Fig. 15 (a). In Fig. 15 (a) and Fig. 15 (b), there are disposed grounding electrodes 71, 72, a signal transmission passage 73, a through-hole 74, a detecting electrode 75, a ceramic supporting substrate 76, an MIM capacitor 77, a semiconductor chip 60 similar to the semiconductor chip used in the inspection apparatus according to the fifth embodiment shown in Fig. 14, Au bumps 78 and a light-shielding resin 79. The signal transmission passage 73 transversely extends on the top surface of the ceramic supporting substrate 76 and is divided into three partial transmission passages 73a, 73b, 73c. The grounding electrode 71 is disposed on the entire top surface of the ceramic supporting substrate 76 except for its portion where the signal transmission passage 73 is disposed and for its portion adjacent to the first-mentioned portion. The detecting electrode 75 is disposed at the underside of the left-end portion of the ceramic supporting substrate 76, and the grounding electrode 72 is formed at the entire underside of the ceramic supporting substrate 76 except for its left-end portion. The MIM capacitor 77 has an insulator layer made of strontium titanate held by and between the right-end portion of the partial transmission passage 73a and the left-end portion of the partial transmission passage 73b, each of the partial transmission passages 73a, 73b serving as a metallic layer. Each of the grounding electrodes 71, 72, the signal transmission passage 73 and the detecting electrode 75 is made of an alloy containing 90 % or more of gold, and the detecting electrode 75 is improved in wear resistance in that the surface thereof is coated with a tungsten alloy of 20 µm in thickness. The partial transmission passage 73a and the detecting electrode 75 are connected to each other by an alloy of the type above-mentioned through the through-hole 74 formed in the left-end portion of the ceramic supporting substrate 76.

In the inspection apparatus 70 according to the sixth embodiment, the chip condenser 57 in the inspection apparatus 50 according to the fifth embodiment shown in Fig. 13 (a) and Fig. 13 (b), is replaced with the MIM capacitor 77. Thus, there can be provided an inspection apparatus excellent in high frequency characteristics as compared with the arrangement using a chip condenser.

### (Seventh Embodiment)

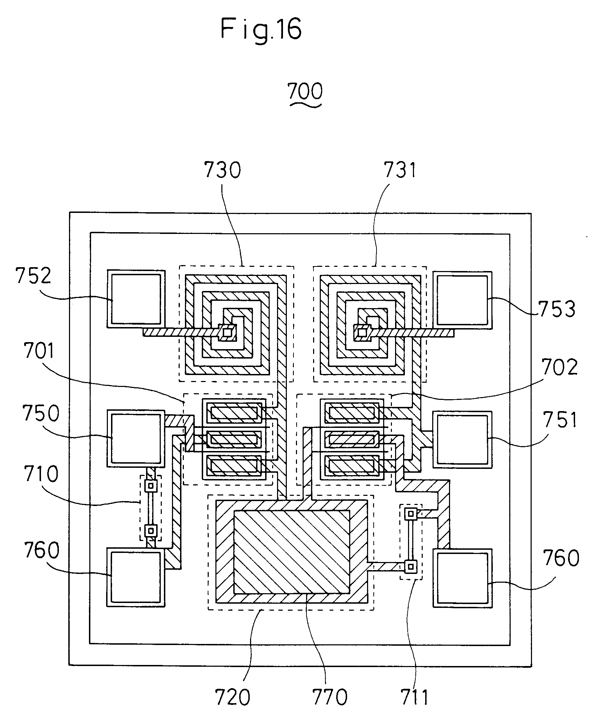

The following description will discuss a semiconductor device and an inspection method according to a seventh embodiment of the present invention with reference to Figs. 16 to 19. As an inspection apparatus, there is used apparatus similar to the inspection apparatus 10 according to the first embodiment shown in Fig. 1 (a) and Fig. 1 (b).

First, there is discussed a semiconductor device according to the seventh embodiment.

Fig. 16 shows a semiconductor device 700 according to the seventh embodiment. Shown in Fig. 16 are FETs 701, 702, resistors 710, 711, and a capacitor 720 which is an MIM capacitor comprising a first wiring metallic layer formed on a semiconductor substrate, an insulator layer formed on the first wiring metallic layer and a second wiring metallic layer formed on the insulator layer, the second wiring metallic layer serving as an upper electrode. There are also disposed inductors 730, 731, an input pad 750, an output pad 751, power source pads 752, 753, grounding pads 760 and a metallic layer 770 formed on an insulator protective layer formed on the MIM capacitor 720.

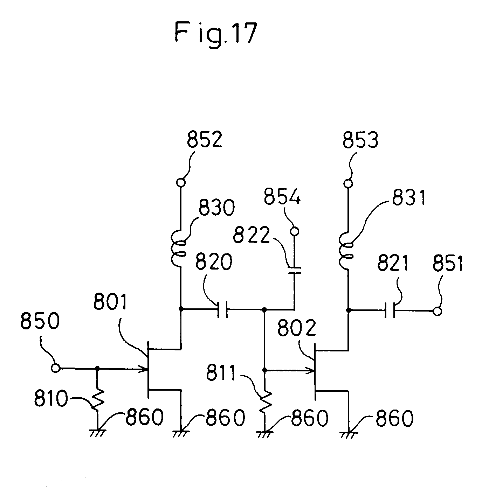

Fig. 17 shows an equivalent circuit of the semiconductor device 700 having the arrangement above-mentioned. Shown in Fig. 17 are FETs 801, 802 corresponding to the FETs 701, 702 shown in Fig. 16, and resistors 810, 811 corresponding to the resistors 710, 711. By these resistors 810, 811, the gate-source bias voltages in the FETs 801, 802 are set to 0 V. Capacitors 820, 821 are disposed for interrupting a low frequency component and a direct current component of a signal, causing only a high frequency component thereof to be transmitted. The capacitor 820 is corresponding to the MIM capacitor 720 shown in Fig. 16. Inductors 830, 831 correspond to the inductors 730, 731 shown in Fig. 16, and are disposed for giving a direct current to the FETs 801, 802 and for preventing a RF signal from escaping to the power source side. There are also disposed an RF signal input terminal 850 corresponding to the input pad 750 shown in Fig. 16, an RF signal output terminal 851 corresponding to the output pad 751, power source terminals 852, 853 corresponding to the power source pads 752, 753, grounding terminals 860 corresponding to the grounding pads 760 and an external terminal 854 corresponding to the metallic layer 770. A capacitor 822 comprises the second wiring metallic layer serving as the upper electrode of the MIM capacitor 720 shown in Fig. 16, the insulator protective layer on the second wiring metallic layer and the metallic layer 770 on the insulator protective layer.

The following description will discuss the inspection method according to the seventh embodiment of inspecting the semiconductor device 700 having the arrangement above-mentioned.

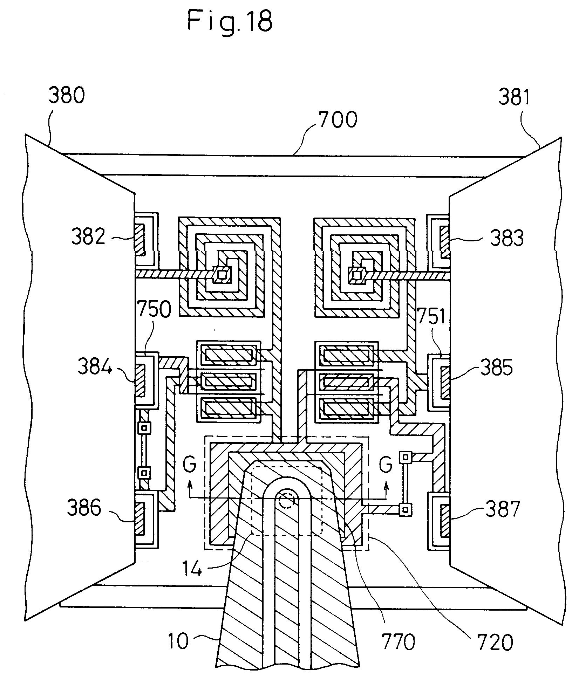

In Fig. 18 which shows the inspection method above-mentioned, there are shown an inspection apparatus 10 similar to the inspection apparatus according to the first embodiment shown in Fig. 1 (a) and Fig. 1 (b), a detecting electrode 14, and the semiconductor device 700 according to the seventh embodiment. There are also shown the MIM capacitor 720, the metallic layer 770, the input pad 750, the output pad 751, and high frequency probes 380, 381. The high frequency probe 380 has a power source contact electrode 382, an input contact electrode 384 and a grounding contact electrode 386. The high frequency probe 381 has a power source contact electrode 383, an output contact electrode 385 and a grounding contact electrode 387. In Fig. 18, the input contact electrode 384 of the high frequency probe 380 is contacted with the input pad 750 of the high frequency semiconductor device 700, the output contact electrode 385 of the high frequency probe 381 is contacted with the output pad 751 of the high frequency semiconductor device 700, and the detecting electrode 14 of the inspection apparatus 10 is contacted with the metallic layer 770 of the high frequency semiconductor device 700. The arrangement in Fig. 18 is equivalent to Fig. 17 when the detecting electrode 14 of the inspection apparatus 10 is connected to the external terminal 854 in Fig. 17.

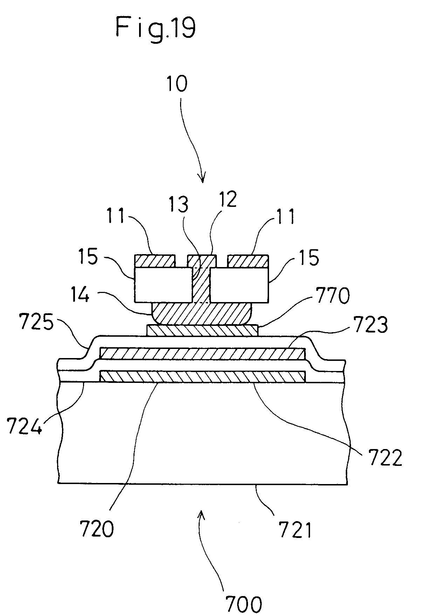

Fig. 19 is a section view taken along the line G-G in Fig. 18. In Fig. 19, there are shown an inspection apparatus 10 similar to the inspection apparatus according to the first embodiment shown in Fig. 1 (a) and Fig. 1 (b), a grounding electrode 11, a signal transmission passage 12, a through-hole 13, a detecting electrode 14, a ceramic supporting substrate 15, and the high frequency semiconductor device 700 according to the seventh embodiment shown in Fig. 16. The high frequency semiconductor device 700 has a semiconductor substrate 721, a first wiring metallic layer 722 formed on the semiconductor substrate 721, an insulator layer 724 formed as extending from the first wiring metallic layer onto the semiconductor substrate 721, and a second wiring metallic layer 723 formed on the insulator layer 724. The MIM capacitor 720 is formed by (i) the first wiring metallic layer 722, (ii) the second wiring metallic layer 723 and (iii) that portion of the insulator layer 724 which is interposed between the first and second wiring metallic layers. An insulator protective layer 725 is formed as extending from the MIM capacitor 720 onto the insulator layer 724. The metallic layer 770 is formed on the insulator protective layer 725.

As discussed in the foregoing, in the semiconductor device 700 according to the seventh embodiment, (i) the second wiring metallic layer 723 of the MIM capacitor 720 of the semiconductor device 700, (ii) the metallic layer 770 and (iii) that portion of the insulator protective layer 725 which is interposed between the second wiring metallic layer 723 and the metallic layer 770, serve as a capacitor. Accordingly, there can be obtained a more stabilized signal value as compared with the first embodiment, thus improving the inspection in accuracy.

According to the inspection method of the seventh embodiment, by contacting the detecting electrode 14 of the inspection apparatus 10 with the metallic layer 770 of the semiconductor device 700, there can be reduced a measurement error resulting from positional shift of the detecting electrode 14 of the inspection apparatus 10. Further, the inspection method of the seventh embodiment can reduce the detecting electrode 14 in wear as compared with a method in which the detecting electrode 14 of the inspection apparatus 10 comes in direct contact with the insulator protective layer 725 of the semiconductor device 700.

## Claims

1. An inspection apparatus comprising:
an insulator substrate made of a material having a high dielectric constant;
a signal transmission passage made of an electrically conductive material and formed on the top surface of said insulator substrate;
a grounding electrode made of an electrically conductive material and formed at least on the top surfaces of those portions of said insulator substrate which are opposite to each other with another portion of said insulator substrate where said signal transmission passage is disposed held therebetween;
a microstrip line formed by said signal transmission passage and those portions of said grounding electrode which are opposite to each other with said signal transmission passage held therebetween; and
a detecting electrode made of an electrically conductive material and formed at the underside of said insulator substrate, said detecting electrode being electrically connected to said signal transmission passage through a through-hole formed in said insulator substrate.

2. An inspection apparatus according to Claim 1, wherein
the signal transmission passage is divided into first, second and third partial transmission passages, and
the microstrip line has (i) a capacitor having one electrode electrically connected to said first partial transmission passage and the other electrode electrically connected to said second partial transmission passage, and (ii) a transistor of which each electrode is electrically connected, by wire bonding, to the grounding electrode, said second partial transmission passage or said third partial transmission passage, said transistor being adapted to amplify a high frequency signal.

3. An inspection apparatus according to Claim 2, wherein
each of the one and the other electrodes of the capacitor comprises a metallic layer, and
said capacitor is an MIM capacitor comprising said metallic layers and an insulator layer made of a material having a high dielectric constant and interposed between said metallic layers.

4. An inspection apparatus according to Claim 1, wherein
the signal transmission passage is divided into first, second and third partial transmission passages, and
the microstrip line has (i) a capacitor having one electrode electrically connected to said first partial transmission passage and the other electrode electrically connected to said second partial transmission passage, and (ii) a transistor of which each electrode is electrically connected, by flip chip bonding, to the grounding electrode, said second partial transmission passage or said third partial transmission passage, said transistor being adapted to amplify a high frequency signal.

5. An inspection apparatus according to Claim 4, wherein
each of the one and the other electrodes of the capacitor comprises a metallic layer,
said capacitor is an MIM capacitor comprising said metallic layers and an insulator layer made of a material having a high dielectric constant and interposed between said metallic layers.

6. An inspection apparatus comprising:
an insulator substrate made of a material having a high dielectric constant;
a signal transmission passage made of an electrically conductive material and formed inside of said insulator substrate;
a detecting electrode made of an electrically conductive material and formed at the underside of said insulator substrate, said detecting electrode being electrically connected to said signal transmission passage through an introduction hole which is formed in said insulator substrate and which extends to the inside from said underside thereof;
a first grounding electrode made of an electrically conductive material and formed on the entire top surface of said insulator substrate; and
a second grounding electrode made of an electrically conductive material and formed at the entire underside of said insulator substrate except for its portion where said detecting electrode is disposed and for its portion adjacent to said first-mentioned portion.

7. An inspection apparatus according to Claim 6, wherein the signal transmission passage is divided into first, second and third partial transmission passages,
said inspection apparatus further comprising:
a capacitor having one electrode electrically connected to said first partial transmission passage and the other electrode electrically connected to said second partial transmission passage; and
a transistor of which each electrode is electrically connected, by wire bonding, to the first grounding electrode, the second grounding electrode, said second partial transmission passage or said third partial transmission passage, said transistor being adapted to amplify a high frequency signal.

8. An inspection apparatus according to Claim 7, wherein
each of the one and the other electrodes of the capacitor comprises a metallic layer, and
said capacitor is an MIM capacitor comprising said metallic layers and an insulator layer made of a material having a high dielectric constant and interposed between said metallic layers.

9. An inspection apparatus according to Claim 6, wherein the signal transmission passage is divided into first, second and third partial transmission passages,
said inspection apparatus further comprising:
a capacitor having one electrode electrically connected to said first partial transmission passage and the other electrode electrically connected to said second partial transmission passage; and
a transistor of which each electrode is electrically connected, by flip chip bonding, to the first grounding electrode, the second grounding electrode, said second partial transmission passage or said third partial transmission passage, said transistor being adapted to amplify a high frequency signal.

10. An inspection apparatus according to Claim 9, wherein
each of the one and the other electrodes of the capacitor comprises a metallic layer, and
said capacitor is an MIM capacitor comprising said metallic layers and an insulator layer made of a material having a high dielectric constant and interposed between said metallic layers.

11. A method of inspecting a semiconductor device with the use of an inspection apparatus, in which
said semiconductor device comprises (i) an MIM capacitor having a first metallic layer formed on a semiconductor substrate, an insulator layer formed on said first metallic layer and a second metallic layer formed on said insulator layer, and (ii) an insulator protective layer formed on said MIM capacitor,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said insulator protective layer of said semiconductor device, said detecting electrode of said inspection apparatus is adapted to supply a high frequency signal to said MIM capacitor of said semiconductor device, so that the high frequency characteristics of said semiconductor device are inspected.

12. A method of inspecting a semiconductor device with the use of an inspection apparatus, in which
said semiconductor device comprises (i) an MIM capacitor having a first metallic layer formed on a semiconductor substrate, an insulator layer formed on said first metallic layer and a second metallic layer formed on said insulator layer, and (ii) an insulator protective layer formed on said MIM capacitor,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said insulator protective layer of said semiconductor device, said detecting electrode of said inspection apparatus is adapted to receive a high frequency signal from said MIM capacitor of said semiconductor device, so that the high frequency characteristics of said semiconductor device are inspected.

13. An inspection method according to Claim 12, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by wire bonding, to the grounding electrode, said second partial transmission passage or said third partial transmission passage, said transistor being adapted to amplify a high frequency signal.

14. An inspection method according to Claim 13, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

15. An inspection method according to Claim 12, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by flip chip bonding, to the grounding electrode, said second partial transmission passage or said third partial transmission passage, said transistor being adapted to amplify a high frequency signal.

16. An inspection method according to Claim 15, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

17. A method of inspecting a semiconductor device with the use of an inspection apparatus, in which
said semiconductor device comprises (i) an MIM capacitor having a first metallic layer formed on a semiconductor substrate, an insulator layer formed on said first metallic layer and a second metallic layer formed on said insulator layer, and (ii) an insulator protective layer formed on said MIM capacitor,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said insulator protective layer of said semiconductor device, said detecting electrode of said inspection apparatus is adapted to supply a high frequency signal to said MIM capacitor of said semiconductor device, so that the high frequency characteristics of said semiconductor device are inspected.

18. A method of inspecting a semiconductor device with the use of an inspection apparatus, in which
said semiconductor device comprises (i) an MIM capacitor having a first metallic layer formed on a semiconductor substrate, an insulator layer formed on said first metallic layer and a second metallic layer formed on said insulator layer, and (ii) an insulator protective layer formed on said MIM capacitor,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said insulator protective layer of said semiconductor device, said detecting electrode of said inspection apparatus is adapted to receive a high frequency signal from said MIM capacitor of said semiconductor device, so that the high frequency characteristics of said semiconductor device are inspected.

19. An inspection method according to Claim 18, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by wire bonding, to the first grounding electrode, the second grounding electrode, said second partial transmission passage or said third partial transmission passage, said transistor being adapted to amplify a high frequency signal.

20. An inspection method according to Claim 19, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

21. An inspection method according to Claim 18, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by flip chip bonding, to the first grounding electrode, the second grounding electrode, said second partial transmission passage or said third partial transmission passage, said transistor being adapted to amplify a high frequency signal.

22. An inspection method according to Claim 21, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

23. A method of inspecting a semiconductor device with the use of an inspection apparatus, in which
said semiconductor device comprises (i) a wiring layer formed on a semiconductor substrate and (ii) an insulator protective layer formed on said wiring layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said insulator protective layer of said semiconductor device, said detecting electrode of said inspection apparatus is adapted to supply a high frequency signal to said wiring layer of said semiconductor device, so that the high frequency characteristics of said semiconductor device are inspected.

24. A method of inspecting a semiconductor device with the use of an inspection apparatus, in which
said semiconductor device comprises (i) a wiring layer formed on a semiconductor substrate and (ii) an insulator protective layer formed on said wiring layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said insulator protective layer of said semiconductor device, said detecting electrode of said inspection apparatus is adapted to receive a high frequency signal from said wiring layer of said semiconductor device, so that the high frequency characteristics of said semiconductor device are inspected.

25. An inspection method according to Claim 24, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by wire bonding, to the grounding electrode, said second partial transmission passage or said third partial transmission passage, said transistor being adapted to amplify a high frequency signal.

26. An inspection method according to Claim 25, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

27. An inspection method according to Claim 24, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by flip chip bonding, to the grounding electrode, said second partial transmission passage or said third partial transmission passage, said transistor being adapted to amplify a high frequency signal.

28. An inspection method according to Claim 27, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

29. A method of inspecting a semiconductor device with the use of an inspection apparatus, in which
said semiconductor device comprises (i) a wiring layer formed on a semiconductor substrate and (ii) an insulator protective layer formed on said wiring layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said insulator protective layer of said semiconductor device, said detecting electrode of said inspection apparatus is adapted to supply a high frequency signal to said wiring layer of said semiconductor device, so that the high frequency characteristics of said semiconductor device are inspected.

30. A method of inspecting a semiconductor device with the use of an inspection apparatus, in which
said semiconductor device comprises (i) a wiring layer formed on a semiconductor substrate and (ii) an insulator protective layer formed on said wiring layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said insulator protective layer of said semiconductor device, said detecting electrode of said inspection apparatus is adapted to receive a high frequency signal from said wiring layer of said semiconductor device, so that the high frequency characteristics of said semiconductor device are inspected.

31. An inspection method according to Claim 30, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by wire bonding, to the first grounding electrode, the second grounding electrode, said second partial transmission passage or said third partial transmission passage, said transistor being adapted to amplify a high frequency signal.

32. An inspection method according to Claim 31, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

33. An inspection method according to Claim 30, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by flip chip bonding, to the first grounding electrode, the second grounding electrode, said second partial transmission passage or said third partial transmission passage, said transistor being adapted to amplify a high frequency signal.

34. An inspection method according to Claim 33, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

35. A semiconductor device comprising:
an MIM capacitor having a first metallic layer formed on a semiconductor substrate, an insulator layer formed on said first metallic layer and a second metallic layer formed on said insulator layer;
an insulator protective layer formed on said MIM capacitor; and
an electrical conductor layer made of an electrically conductive material and formed on said insulator protective layer.

36. A semiconductor device comprising:
a wiring layer formed on a semiconductor substrate;
an insulator protective layer formed on said wiring layer; and
an electrical conductor layer made of an electrically conductive material and formed on said insulator protective layer.

37. A method of inspecting a semiconductor device with the use of an inspection apparatus, in which
said semiconductor device comprises: (i) an MIM capacitor having a first metallic layer formed on a semiconductor substrate, an insulator layer formed on said first metallic layer and a second metallic layer formed on said insulator layer; (ii) an insulator protective layer formed on said MIM capacitor; and (iii) an electrical conductor layer made of an electrically conductive material and formed on said insulator protective layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said electrical conductor layer of said semiconductor device, said detecting electrode of said inspection apparatus is adapted to supply a high frequency signal to said MIM capacitor of said semiconductor device, so that the high frequency characteristics of said semiconductor device are inspected.

38. A method of inspecting a semiconductor device with the use of an inspection apparatus, in which
said semiconductor device comprises: an MIM capacitor having a first metallic layer formed on a semiconductor substrate, an insulator layer formed on said first metallic layer and a second metallic layer formed on said insulator layer; an insulator protective layer formed on said MIM capacitor; and an electrical conductor layer made of an electrically conductive material and formed on said insulator protective layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said electrical conductor layer of said semiconductor device, said detecting electrode of said inspection apparatus is adapted to receive a high frequency signal from said MIM capacitor of said semiconductor device, so that the high frequency characteristics of said semiconductor device are inspected.

39. An inspection method according to Claim 38, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by wire bonding, to the grounding electrode, said second partial transmission passage or said third partial transmission passage, said transistor being adapted to amplify a high frequency signal.

40. An inspection method according to Claim 39, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

41. An inspection method according to Claim 38, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by flip chip bonding, to the grounding electrode, said second partial transmission passage or said third partial transmission passage, said transistor being adapted to amplify a high frequency signal.

42. An inspection method according to Claim 41, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

43. A method of inspecting a semiconductor device with the use of an inspection apparatus, in which
said semiconductor device comprises: (i) an MIM capacitor having a first metallic layer formed on a semiconductor substrate, an insulator layer formed on said first metallic layer and a second metallic layer formed on said insulator layer; (ii) an insulator protective layer formed on said MIM capacitor; and (iii) an electrical conductor layer made of an electrically conductive material and formed on said insulator protective layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said electrical conductor layer of said semiconductor device, said detecting electrode of said inspection apparatus is adapted to supply a high frequency signal to said MIM capacitor of said semiconductor device, so that the high frequency characteristics of said semiconductor device are inspected.

44. A method of inspecting a semiconductor device with the use of an inspection apparatus, in which
said semiconductor device comprises: (i) an MIM capacitor having a first metallic layer formed on a semiconductor substrate, an insulator layer formed on said first metallic layer and a second metallic layer formed on said insulator layer; (ii) an insulator protective layer formed on said MIM capacitor; and (iii) an electrical conductor layer made of an electrically conductive material and formed on said insulator protective layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said electrical conductor layer of said semiconductor device, said detecting electrode of said inspection apparatus is adapted to receive a high frequency signal from said MIM capacitor of said semiconductor device, so that the high frequency characteristics of said semiconductor device are inspected.

45. An inspection method according to Claim 44, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by wire bonding, to the first grounding electrode, the second grounding electrode, said second partial transmission passage or said third partial transmission passage, said transistor being adapted to amplify a high frequency signal.

46. An inspection method according to Claim 45, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

47. An inspection method according to Claim 44, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by flip chip bonding, to the first grounding electrode, the second grounding electrode, said second partial transmission passage or said third partial transmission passage, said transistor being adapted to amplify a high frequency signal.

48. An inspection method according to Claim 47, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

49. A method of inspecting a semiconductor device with the use of an inspection apparatus, in which
said semiconductor device comprises: a wiring layer formed on a semiconductor substrate; an insulator protective layer formed on said wiring layer; and an electrical conductor layer made of an electrically conductive material and formed on said insulator protective layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is dispose held therebetween; a microstrip line formed by said signal transmission passage and those portions of said grounding electrode which are opposite to each other with another portion of said insulator substrate where said signal transmission passage is dispose held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said electrical conductor layer of said semiconductor device, said detecting electrode of said inspection apparatus is adapted to supply a high frequency signal to said wiring layer of said semiconductor device, so that the high frequency characteristics of said semiconductor device are inspected.

50. A method of inspecting a semiconductor device with the use of an inspection apparatus, in which
said semiconductor device comprises: a wiring layer formed on a semiconductor substrate; an insulator protective layer formed on said wiring layer; and an electrical conductor layer made of an electrically conductive material and formed on said insulator protective layer,
said inspection apparatus comprises: an insulator substrate made of a material having a high dielectric constant; a signal transmission passage made of an electrically conductive material and formed on the top surface of said insulator substrate; a grounding electrode made of an electrically conductive material and formed at least on the top surfaces of those portions of said insulator substrate which are opposite to each other with another portion of said insulator substrate where said signal transmission passage is disposed held therebetween; a microstrip line formed by said signal transmission passage and those portions of said grounding electrode which are opposite to each other with said signal transmission passage held therebetween; and a detecting electrode made of an electrically conductive material and formed at the underside of said insulator substrate, said detecting electrode being electrically connected to said signal transmission passage through a through-hole formed in said insulator substrate, and
with said detecting electrode of said inspection apparatus brought close to or contacted with said electrical conductor layer of said semiconductor device, said detecting electrode of said inspection apparatus is adapted to receive a high frequency signal from said wiring layer of said semiconductor device, so that the high frequency characteristics of said semiconductor device are inspected.

51. An inspection method according to Claim 50, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by wire bonding, to the grounding electrode, said second partial transmission passage or said third partial transmission passage, said transistor being adapted to amplify a high frequency signal.

52. An inspection method according to Claim 51, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

53. An inspection method according to Claim 50, wherein
the signal transmission passage of the inspection apparatus is divided into first, second and third partial transmission passages, and
the microstrip line of said inspection apparatus has (i) a capacitor having one electrode electrically connected to said first partial transmission passage and the other electrode electrically connected to said second partial transmission passage, and (ii) a transistor of which each electrode is electrically connected, by flip chip bonding, to the grounding electrode, said second partial transmission passage or said third partial transmission passage, said transistor being adapted to amplify a high frequency signal.

54. An inspection method according to Claim 53, wherein
each of the one and the other electrodes of the capacitor of the microstrip line comprises a metallic layer, and
said capacitor is an MIM capacitor comprising said metallic layers and an insulator layer made of a material having a high dielectric constant and interposed between said metallic layers.

55. A method of inspecting a semiconductor device with the use of an inspection apparatus, in which
said semiconductor device comprises: a wiring layer formed on a semiconductor substrate; an insulator protective layer formed on said wiring layer; and an electrical conductor layer made of an electrically conductive material and formed on said insulator protective layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said electrical conductor layer of said semiconductor device, said detecting electrode of said inspection apparatus is adapted to supply a high frequency signal to said wiring layer of said semiconductor device, so that the high frequency characteristics of said semiconductor device are inspected.

56. A method of inspecting a semiconductor device with the use of an inspection apparatus, in which
said semiconductor device comprises: a wiring layer formed on a semiconductor substrate; an insulator protective layer formed on said wiring layer; and an electrical conductor layer made of an electrically conductive material and formed on said insulator protective layer,
said inspection apparatus comprises: an insulator substrate made of a material having a high dielectric constant; a signal transmission passage made of an electrically conductive material and formed inside of said insulator substrate; a detecting electrode made of an electrically conductive material and formed at the underside of said insulator substrate, said detecting electrode being electrically connected to said signal transmission passage through an introduction hole which is formed in said insulator substrate and which extends to the inside from said underside thereof; a first grounding electrode made of an electrically conductive material and formed on the entire top surface of said insulator substrate; and a second grounding electrode made of an electrically conductive material and formed at the entire underside of said insulator substrate except for its portion where said detecting electrode is disposed and for its portion adjacent to said first-mentioned portion,
with said detecting electrode of said inspection apparatus brought close to or contacted with said electrical conductor layer of said semiconductor device, said detecting electrode of said inspection apparatus is adapted to receive a high frequency signal from said wiring layer of said semiconductor device, so that the high frequency characteristics of said semiconductor device are inspected.

57. An inspection method according to Claim 56, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by wire bonding, to the first grounding electrode, the second grounding electrode, said second partial transmission passage or said third partial transmission passage, said transistor being adapted to amplify a high frequency signal.

58. An inspection method according to Claim 57, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.

59. An inspection method according to Claim 56, wherein
the signal transmission passage of the inspection apparatus is divided into first, second and third partial transmission passages, and
said inspection apparatus further has (i) a capacitor having one electrode electrically connected to said first partial transmission passage and the other electrode electrically connected to said second partial transmission passage, and (ii) a transistor of which each electrode is electrically connected, by flip chip bonding, to the first grounding electrode, the second grounding electrode, said second partial transmission passage or said third partial transmission passage, said transistor being adapted to amplify a high frequency signal.

60. An inspection method according to Claim 59, wherein
each of the one and the other electrodes of the capacitor of the inspection apparatus comprises a metallic layer, and
said capacitor is an MIM capacitor comprising said metallic layers and an insulator layer made of a material having a high dielectric constant and interposed between said metallic layers.
